# EUROPEAN PATENT APPLICATION

(11) **EP 3 629 389 A1**
(43) Date of publication of application: **01.04.2020**
(21) Application number: 19197058.1
(22) Date of filing: 12.09.2019
(51) Int. Cl.: H01L 41/313, H01L 41/337, H03H 9/02

(54) **A COMPOSITE SUBSTRATE FOR A SURFACE ACOUSTIC WAVE DEVICE AND MANUFACTURING METHOD THEREOF**

(30) Priority: 26.09.2018 JP 2018180459; 19.08.2019 JP 2019149741
(71) Applicant: Shin-Etsu Chemical Co., Ltd., Tokyo 100-0004 (JP)
(72) Inventor: TANNO, Masayuki, Gunma, 379-0195 (JP); KANO, Hiroki, Gunma, 379-0195 (JP); AKIYAMA, Shoji, Gunma, 379-0195 (JP)
(74) Representative: Vossius & Partner Patentanwälte Rechtsanwälte mbB

(57) **Abstract**

Provided is a composite substrate (1) for a surface acoustic wave device in which a chip is hardly generated at an outer peripheral edge of an electric material layer and peeling is hardly generated from the outer peripheral edge. The composite substrate (1) for a surface acoustic wave device is a composite substrate in which a piezoelectric material single crystal thin film (11) and a supporting substrate (12) are bonded at a bonding surface (13). The supporting substrate has a closed first contour line (14), the bonding surface has a closed second contour line (15), and the piezoelectric material single crystal thin film has a closed third contour line (16). When the first contour line (14) and the third contour line (16) are projected perpendicularly to a plane including the bonding surface, the projection image of the first contour line (14) is located outside the second contour line (15), and the projection image of the third contour line (16) is located inside the second contour line (15).

## Description

### BACKGROUND

### Technical Field

The present invention relates to a composite substrate for a surface acoustic wave device in which a piezoelectric material single crystal substrate and a supporting substrate are bonded to each other, and a method of manufacturing the same.

### Background Art

Recently, in mobile communications such as mobile phones and smartphones, high-performance SAW (Surface Acoustic Wave) devices are required when the communication capacity is increased by increasing the number of communication bands.

Lithium tantalate (LT) and lithium niobate (LN), which are piezoelectric materials, are widely used as materials for SAW devices. While these materials have an advantage that they have a large electromechanical coupling coefficient and can broaden the bandwidth of the device, they have a problem that the temperature stability is low and the frequency that can be dealt with shifts due to the temperature changes.

In order to solve this problem, there is a technique in which a piezoelectric material such as LT or LN is bonded to a supporting substrate having a small coefficient of thermal expansion to form a composite substrate in which the piezoelectric material side is thinned to several µm to several tens of µm (see, for example, Non Patent Document: Temperature Compensation Technology for SAW-Duplexer Used in RF Front End of Smartphone, Dempa Shimbun High Technology, Nov. 8, 2012).

In addition, there is a technique for suppressing the occurrence of cracks when thinning by forming a groove along the entire circumference on the inner side of the outer peripheral edge when thinning the piezoelectric material layer of the composite substrate in which the piezoelectric material and the supporting substrate are bonded by an organic adhesive (for example, refer to Japanese Patent Application Laid-Open No. 2011-135535).

On the other hand, there is a technique of a composite substrate in which a piezoelectric material and a supporting substrate are bonded to each other without using an organic adhesive. In such a composite substrate, there is a technique for improving the spurious characteristics of a SAW device by providing a concavo-convex structure on a piezoelectric material or a supporting substrate and bonding the piezoelectric material and the supporting substrate via an inorganic intervening layer, thereby improving reliability such as improvement of heat resistance and suppression of outgas in a subsequent process of manufacturing a device (for example, refer to Japanese Patent Application Laid-Open No. 2018-61226).

### SUMMARY OF THE INVENTION

### PROBLEMS TO BE SOLVED BY THE INVENTION

In such composite substrates, chips generated in the polishing process for thinning the piezoelectric material layer remain at the outer peripheral edge, or the piezoelectric material thin film may be peeled off from the outer peripheral edge by heat in a post-process for making the piezoelectric material layer into a device. In particular, when the piezoelectric material and the supporting substrate are directly bonded or bonded via an inorganic intervening layer, chips generated in the piezoelectric material may reach the intervening layer or the supporting substrate without staying at the bonding surface, and peeling is likely to occur from this portion as a starting point.

The present invention has been made in view of the above-mentioned problems, and an object thereof is to provide a composite substrate and a manufacturing method thereof in which a chip is hardly generated at an outer peripheral edge of a piezoelectric material layer and peeling is hardly generated from the outer peripheral edge.

### MEANS FOR SOLVING THE PROBLEMS

The present inventors have developed a composite substrate and a method of making the same that at least partially solves the above-mentioned problems.

The composite substrate for a surface acoustic wave device of the present invention is a composite substrate in which a piezoelectric material single crystal thin film and a supporting substrate are bonded at a bonding surface, wherein the supporting substrate has a closed first contour line, the bonding surface has a closed second contour line, the piezoelectric material single crystal thin film has a closed third contour line, and when the first contour line and the third contour line are projected perpendicularly to a plane including the bonding surface, the projection image of the first contour line is located outside the second contour line, and the projection image of the third contour line is located inside the second contour line.

The method for manufacturing a composite substrate for a surface acoustic wave device of the present invention includes steps of: preparing a piezoelectric material single crystal substrate and a supporting substrate; bonding the piezoelectric material single crystal substrate and the supporting substrate to form a bonded substrate having a bonding surface; grinding the outer peripheral surface of the bonded substrate to form a closed first contour line on the supporting substrate and forming a second contour line on the bonding surface, forming the outer peripheral surface extending from the first contour line to the surface opposite to the bonding surface of the piezoelectric material single crystal substrate across the second contour line; and polishing and thinning the piezoelectric material single crystal substrate to form a piezoelectric material single crystal thin film having a closed third contour line; when the first contour line and the third contour line are projected perpendicularly onto a plane including the bonding surface, the projection of the first contour line and the third contour line are located outside the second contour line, and the projection image of the third contour line is located inside the second contour line.

### BRIEF DESCRIPTION OF THE DRAWINGS

Fig. 1 is a top view of the composite substrate according to the first embodiment of the present invention and a cross-sectional view taken along a plane perpendicular to the bonding surface.
Fig. 2 is an enlarged cross-sectional view of the composite substrate according to the first embodiment of the present invention in the vicinity of the outer peripheral edge.
Fig. 3 is a top view of a composite substrate according to a second embodiment of the present invention and a cross-sectional view taken along a plane perpendicular to a bonding surface.
Fig. 4 is an enlarged cross-sectional view of the composite substrate according to the second embodiment of the present invention in the vicinity of the outer peripheral edge.
Fig. 5 is an enlarged cross-sectional view of the composite substrate according to the second embodiment of the present invention in the vicinity of the outer peripheral edge.
Fig. 6 is a view showing one embodiment of the method for manufacturing a composite substrate of the present invention.
Fig. 7 is a cross-sectional photograph of the outer periphery of the composite substrate of Example 1.
Fig. 8 is a top view of the composite substrate according to the comparative example and a cross-sectional view taken along a plane perpendicular to the bonding surface.
Fig. 9 is a perspective view of a composite substrate according to the comparative example.

### DETAILED DESCRIPTION OF THE EMBODIMENTS

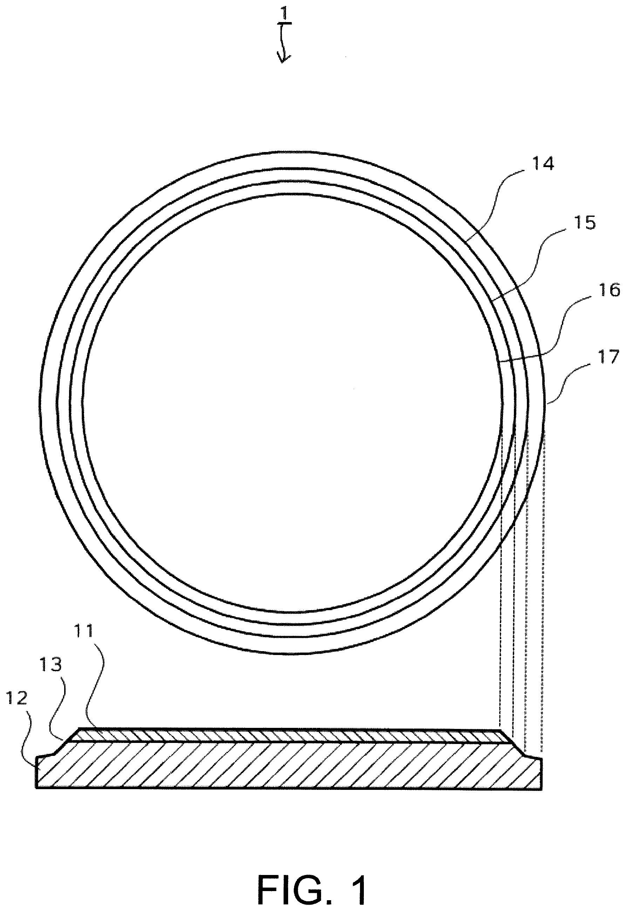

Fig. 1 is a top view of a composite substrate 1 according to the first embodiment of the present invention and a cross-sectional view taken along a plane perpendicular to the bonding surface. The composite substrate 1 has a disk shape, and a piezoelectric material single crystal thin film 11 and a supporting substrate 12 are bonded to each other at a bonding surface 13. In this embodiment, the piezoelectric material single crystal 11 and the supporting substrate 12 are directly bonded to each other. As the piezoelectric material, LT or LN is preferably used. As the supporting substrate, a material having a coefficient of thermal expansion as low as possible is preferably used, and silicon, sapphire, alumina, glass, silicon carbide, aluminum nitride, or silicon nitride can be used.

Here, the supporting substrate 12 has a closed first contour line 14. The bonding surface 13 also has a closed second contour line 15. The piezoelectric material single crystal thin film 11 has a closed third contour line 16.

The region from the first contour line 14 to the third contour line 16 through the second contour line 15 is preferably an outer peripheral surface connected continuously. "Connected continuously" means that the slope is constant or the change in slope is not discontinuous. For example, a region extending from the first contour line 14 through the second contour line 15 to the third contour line 16 may be an outer peripheral surface having a constant slope.

The second contour line 15 is a closed curve defined by the line of intersection between the outer peripheral surface and the bonding surface of the composite substrate 1. In the cross section through which the second contour line 15 vertically passes, when the absolute value of the inclination with respect to the bonding surface 13 is observed while moving the outer peripheral surface of the supporting substrate 12 from the outermost periphery of the supporting substrate 12 (the point farthest from the radial position) toward the second contour 15, the first contour line 14 is defined as a closed curve continuously connecting the first position where the absolute value, which decreases once, of the inclination start to increase again, for each cross section. Further, in this cross-sectional view, when the absolute value of the inclination with respect to the bonding surface 13 is observed while moving outward from the center of the surface (polishing surface) opposite to the bonding surface 13 of the piezoelectric material thin film toward the second contour line 15, the third contour line 16 is defined as a closed curve continuously connecting the first position at which the absolute value of the inclination which was flat (inclination=0) turns to increase for each cross section.

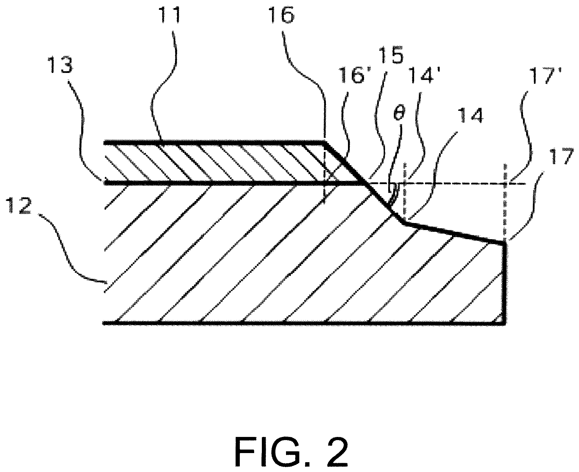

Fig. 2 is an enlarged cross sectional view in the vicinity of the outer peripheral edge of the composite substrate 1 of the first embodiment. When a chip is generated in the vicinity of the outer peripheral edge of the piezoelectric material layer 11 and the crack of the chip reaches the bonding surface 13, the bonding force of the bonding surface 13 is weakened, and peeling is apt to occur. In addition, cracks may further reach the supporting substrate 12, which may be a factor of decreasing the strength of the composite substrate 1 and degradation of the temperature stability of a device manufactured using the composite substrate 1.

When the first contour line 14 as well as the third contour line 16 are projected perpendicularly to the plane containing the bonding surface 13, the projection image 14' of the first contour line 14 is located outside the second contour line 15 and the projection image 16' of the third contour line is located inside the second contour line 15. By adopting such a shape, a chip can be made difficult to occur at the outer peripheral edge of the piezoelectric material layer 11.

It is preferable that the region from the first contour line 14 to the third contour line 16 through the second contour line 15 is an outer peripheral surface connected continuously. By doing so, it is possible to make it difficult for stress concentration to occur in a part of the bonding surface 13. The angle θ between the outer peripheral surface extending from the first contour line 14 to the third contour line 16 and the bonding surface 13 in the cross section through which the second contour line 15 vertically passes is preferably less than 90 degrees, more preferably 30 degrees or more and 70 degrees or less. Such an angle can enhance the effect of suppressing the chip.

Preferably, the supporting substrate 12 further comprises a fourth closed contour line 17. In a cross section through which the second contour line 15 vertically passes, when the absolute value of the inclination with respect to the bonding surface is observed while moving the outer peripheral surface of the supporting substrate 12 from the outermost periphery of the supporting substrate 12 (a point farthest from the center at the radial position) toward the second contour line 15, the fourth contour line 17 is defined as a closed curve continuously connecting the first position at which the absolute value of the inclination which was infinity turns to decrease for each cross section.

At this time, when the fourth contour line 17 is projected perpendicularly to the plane including the bonding surface 13, it is preferable that the projection image 17' of the fourth contour line 17 is formed so as to be outside the projection image 14' of the first contour line. As a result, even when a chip is generated in the outer peripheral portion of the supporting substrate 12, the crack of the chip hardly reaches the bonding surface 13, so that peeling from the outer peripheral portion hardly occurs. The distance between the projection image 14' of the first contour line and the projection image 17' of the fourth contour line is preferably equal to or greater than 1mm, more preferably equal to or greater than 2mm.

Further, it is more preferable that the distance between the first contour line 14 and the projection image 14' is not larger than the distance between the fourth contour line 17 and the projection image 17', because a chip is less likely to occur on the outer periphery of the supporting substrate 12.

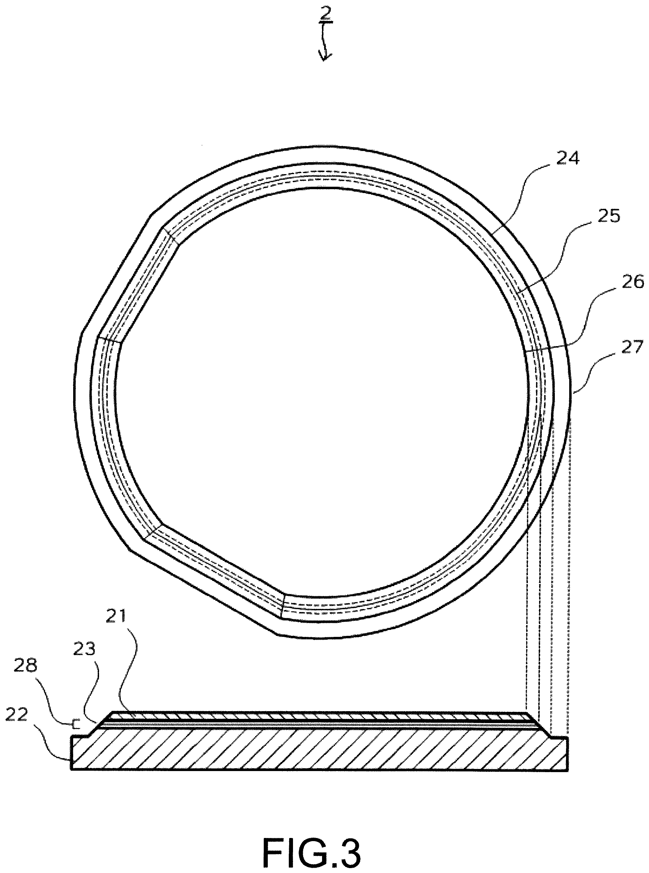

Fig. 3 is a top view of the composite substrate 2 according to the second embodiment of the present invention and a cross-sectional view taken along a plane perpendicular to the bonding surface. The composite substrate 2 is provided with an orientation flat on its outer periphery. In this manner, the crystal orientation of the piezoelectric material single crystal can be easily identified. In this embodiment, a plurality of orientation flats are provided in different orientations. This has the advantage of facilitating alignment when handling the substrate in later steps.

In the second embodiment, the piezoelectric material single crystal 21 and the supporting substrate 22 are bonded to each other by a bonding surface 23. Although the piezoelectric material single crystal 21 and the supporting substrate 22 may be directly bonded to each other, in the case where the bonding surface side of either one or both of the piezoelectric material single crystal 21 and the supporting substrate 22 has a concavo-convex structure, it is preferable to provide the intervening layer 28 therebetween as in this embodiment. By doing so, the surface to be bonded can be mirror-polished without destroying the concavo-convex structure.

Although it is possible to use an organic adhesive for the intervening layer 28, it is preferable to use an inorganic material in consideration of reliability such as thermal degradation and outgassing in a post-process of manufacturing a device from the composite substrate 2. The intervening layer 28 may be formed of a material containing, for example, any of silicon oxide, silicon oxynitride, amorphous silicon, polycrystalline silicon, amorphous silicon carbide, aluminum oxide, aluminum nitride, tungsten, platinum, platinum rhodium, molybdenum, ruthenium, and titanium. The supporting substrate 22 preferably contains an element common to the intervening layer 28. In this manner, the intervening layer 28 can be formed on the surface of the supporting substrate 22 by a chemical reaction such as oxidation, nitridation, carbonization, reduction, or the like. The intervening layer 28 may be formed of a metal material, and the intervening layer 28 may be formed by physical vapor deposition such as sputtering. By doing so, the intervening layer 28 having a stable composition can be formed. In consideration of adhesion to the piezoelectric material single crystal 21, adhesion to the supporting substrate 22, adhesion at the bonding interface, and the like, the intervening layer 28 may be formed of a plurality of layers.

In the second embodiment, since the intervening layer 28 is provided on both the piezoelectric material single crystal 21 and the supporting substrate 22 and bonded to each other, the bonding surface 23 exists inside the intervening layer 28. At this time, the material of the intervening layer 28 provided on the piezoelectric material single crystal 21 side and the material of the intervening layer 28 provided on the supporting substrate 22 side with the bonding surface 23 interposed therebetween may be different from each other, and a multilayer film structure composed of a plurality of materials may be employed. Further, when the intervening layer 28 is provided only on the piezoelectric material single crystal 21, the bonding surface 23 exists at the interface between the intervening layer 28 and the supporting substrate 22. Conversely, when the intervening layer 28 is provided only on the supporting substrate 22, the bonding surface 23 exists at the interface between the intervening layer 28 and the piezoelectric material single crystal 21.

In this embodiment, the supporting substrate 22 has a closed first contour line 24 as well as a fourth contour line 27. The bonding surface 23 also has a closed second contour line 25. The piezoelectric material single crystal 21 has a closed third contour line 26.

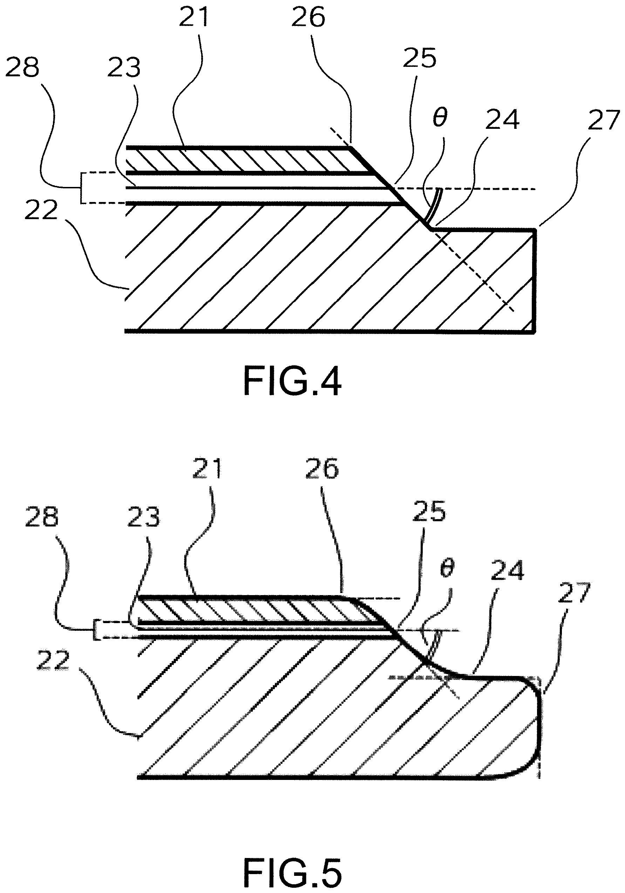

Fig. 4 is an enlarged cross-sectional view in the vicinity of the outer peripheral edge of the composite substrate according to the second embodiment.

When a chip is generated in the vicinity of the outer peripheral edge of the piezoelectric material single crystal 21 and the crack of the chip reaches the bonding surface 23, the bonding force of the bonding surface 23 is weakened and peeling is apt to occur. In particular, when the intervening layer 28 is made of an inorganic material, cracks in the chip can easily reach the bonding surface 23 as compared with the case where the intervening layer 28 is made of an organic adhesive. In addition, cracks may further reach the supporting substrate 22, which may cause the strength of the composite substrate 2 to be decreased and the temperature stability of a device manufactured using the composite substrate 2 to be degraded.

When the first contour line 24 and the third contour line 26 are projected perpendicularly to the plane including the bonding surface 23, the projection image of the first contour line 24 is located outside the second contour line 25, and the projection image of the third contour line 26 is located inside the second contour line 25. By adopting such a shape, a chip can be made difficult to occur at the outer peripheral edge of the piezoelectric material single crystal 21.

The region from the first contour line 24 through the second contour line 25 to the third contour line 26 is a continuously connected outer peripheral surface, and the angle θ formed by the outer peripheral surface and the bonding surface 23 is defined as the angle formed by the outer peripheral surface and the bonding surface 23 from the first contour line 24 to the third contour line 26 in the cross section through which the second contour line 25 vertically passes. As shown in Fig. 5, when the angle (inclination) of the outer peripheral surface from the first contour line 24 to the third contour line 26 continuously changes, the angle formed by the tangent line of the maximum inclination and the bonding surface 23 is defined as the angle θ. The angle θ is preferably less than 90 degrees, and particularly preferably 30 degrees or more and 70 degrees or less. By setting the angle θ as described above, the effect of suppressing the chip can be enhanced.

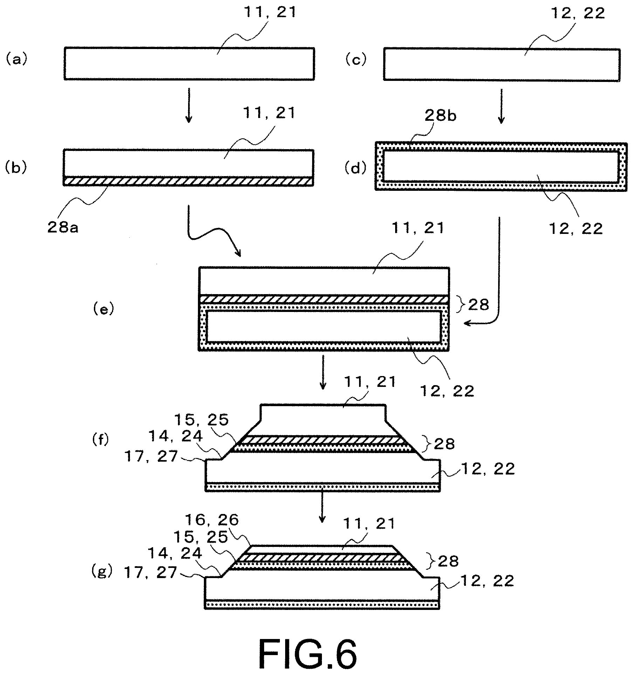

Fig. 6 is a view showing one embodiment of the method for manufacturing a composite substrate of the present invention.

A single crystal LT substrate is prepared as the piezoelectric material single crystal (11, 21) ((a) in Fig. 6). As the piezoelectric material single crystal (11, 21), a single crystal LN substrate may be used instead of the single crystal LT substrate ((c) in Fig. 6). A single crystal silicon substrate is prepared as the supporting substrate (12, 22). Instead of silicon, sapphire, alumina, glass, silicon carbide, aluminum nitride, and silicon nitride can be used as the supporting substrate (12, 22).

Next, a SiO₂ film 28a to be an intervening layer (28) is formed on a surface of the single-crystal LT substrates (11, 21) by CVD or the like ((b) in Fig. 6). In addition, the single crystal silicon substrate (12, 22) is heated in an oxygen atmosphere to form a thermally oxidized silica layer 28b serving as an intervening layer 28 on the surface ((d) in Fig. 6). Here, depending on the design of the composite substrate, the intervening layer 28 may be formed only on the single crystal LT substrate (11, 21) or only on the silicon substrate (12, 22). In addition, it is not necessary to form the intervening layer 28, which corresponds to the composite substrate 1 of the first embodiment.

Next, with respect to each of the single crystal LT substrate (11, 21) and the supporting substrate (12, 22), the surface to be bonded (the intervening layer when it is provided, or the substrate itself when it is not provided) is polished and mirrored. Thereafter, both are bonded to form a bonded substrate ((e) in Fig. 6). Note that it is preferable to bond the mirrored surface after activation by a plasma activation method or the like. By doing so, the bonding strength at the bonding surface can be increased. Instead of the plasma activation method, an ion beam activation method or an ozone water activation method can be used as a surface activation method. In the plasma activation method, a plasma gas is introduced into a reaction vessel on which a substrate to be processed is placed, a high-frequency plasma of about 100W is formed under a reduced pressure of about 0.01 to 0.1Pa, and the bonded surface of the substrate is exposed to the plasma for about 5 to 50 seconds. As the plasma gas, oxygen, hydrogen, nitrogen, argon, or a mixed gas thereof can be used. In the ion beam activation method, the inside of a reactor is evacuated to a high vacuum of 1×10⁻⁵ Pa or less, and an ion beam of argon or the like is applied to a bonding surface of a substrate to be processed to scan the substrate. In the ozone water activation method, ozone gas is introduced into pure water to form ozone water, and the substrate is immersed in the ozone water, whereby the bonding surface can be activated with active ozone.

Then, the outer peripheral surface of the bonded substrate stack is ground to form a closed first contour line (14, 24) on the supporting substrate (12, 22) and a second contour line (15, 25) on the bonding surface to form an outer peripheral surface extending from the first contour line (14, 24) to a surface opposite to the bonding surface of the LT substrate bonded across the second contour line (15, 25) ((f) in Fig. 6). At this time, when the first contour lines (14, 24) are projected perpendicularly to the plane including the bonding surface, the projection image of the first contour line (14, 24) is formed so as to be located outside the second contour line (15, 25). Among the outer peripheral grinding surfaces, the outer peripheral surface passing from the first contour line (14, 24) through the second contour line (15, 25) to the single crystal LT substrate is continuously connected, and it is preferable that the outer peripheral surface is continuous at least up to the thickness of the single crystal LT layer to be thinned in the next step and left on the composite substrate. At this time, the fourth contour line (17, 27) may be provided in the portion of the silicon substrate outside the first contour line (14, 24). The fourth contour line (17, 27) is formed such that the projection image when the fourth contour line (17, 27) is projected perpendicularly onto the bonding surface is outside the projection image of the first contour line (14, 24). It is preferable that the distance between the projection image of the fourth contour line (17, 27) and the projection image of the first contour line (14, 24) is 1mm or more, because the crack does not easily reach the bonding surface when a chip occurs at the outer peripheral portion of the supporting substrate. It is more preferable that the distance between the projection image of the fourth contour line (17, 27) and the projection image of the first contour line (14, 24) is 2mm or more.

Thereafter, the surface of the bonded substrate on the single crystal LT substrate (11, 21) side is ground and polished to be thinned to a desired thickness, thereby forming the closed third contour line (16, 26) in the single crystal LT layer ((g) in Fig. 6). Here, when the third contour line (16, 26) is projected perpendicularly to the bonding surface, the projection image of the third contour line (16, 26) may be formed so as to be located inside the second contour line (15, 25). By doing so, it is possible to prevent chips from being generated in the single crystal LT layer (11, 21).

### Example

Hereinafter, examples of the present invention will be described in more detail.

### <EXAMPLE 1>

In Example 1, first, single-crystal LT substrate of 6 inch diameter and 46.3°Y-cut having a concavo-convex structure having the arithmetic mean roughness Ra (Ra=140nm±10%) and a RSm/λ = 0.6, where the device operating wavelength λ is 5µm, was prepared. The maximum height roughness Rz of the 6-inch LT substrate having the concavo-convex structure was 2.0µm.

Next, on the surface of the LT substrate having the concavo-convex structure, about 10µm of SiO₂ was deposited by plasma-enhanced CVD at 35° C. Thereafter, the surface on which the SiO₂ was deposited was polished to form a mirror surface. The SiO₂ was polished to a thickness of about 3µm. In addition, a Si substrate having a thickness of 680µm serving as a supporting substrate was subjected to heat treatment at 850 °C in an oxygen atmosphere, whereby thermally oxidized silica having a thickness of 200nm was formed on the surface of the Si substrate. Then, both of the SiO₂ mirror surface formed on the LT substrate and the thermally oxidized silica formed on the surface of the Si substrates were plasma-activated and bonded to each other to produce a bonded substrate of 6 inch diameter.

Next, the outer periphery of the 6 inch bonded substrate was ground by a chamfering machine, and thereby, a first contour line and a fourth contour line were formed on the supporting substrate, and a second contour line was formed on the bonding surface. Further, the LT substrate portion of the bonded substrate was polished and thinned to 12µm to form a third contour line, thereby a composite substrate is manufactured.

The grinding surface from the first contour line to the fourth contour line of the manufactured composite substrate was formed to have a plane parallel to the bonding surface. The distance between the first contour line and the fourth contour line was 2.25mm. The grinding surface from the first contour line to the third contour line through the second contour line formed a continuous outer peripheral surface. In the cross section perpendicular to the bonding surface and the tangent line of the second contour line, the angle formed between the bonding surface and the outer peripheral surface was 45 degrees.

In the composite substrate thus manufactured, chips were not generated in the outer peripheral portion of the polished LT substrate portion.

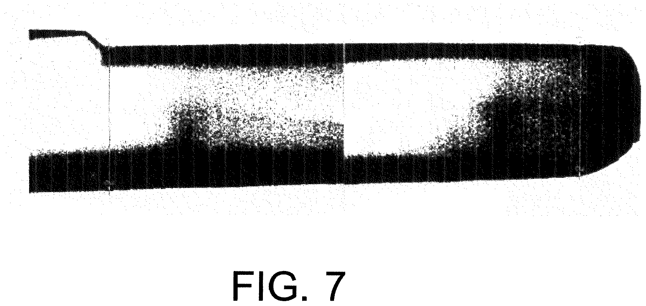

Further, this composite substrate was heated to 300°C with a hot plate, but peeling did not occur at the outer periphery of the bonding surface. Fig. 7 is a cross-sectional photograph of the outer periphery of the composite substrate of Example 1.

### <EXAMPLES 2 to 15>

In the same manner as in Example 1, an intervening layer was provided on a single crystal LT substrate of 6 inch diameter and a single crystal silicon substrate. Then, after the surface of each intervening layer was mirror-finished, the plasma activation is performed and both substrate were bonded to each other on the surface of the intervening layer. In this way, a plurality of bonded substrates were produced. Next, the outer periphery of the bonded substrate was ground by a chamfering machine, and thereby, a first contour line and a fourth contour line are formed on the supporting substrate, and a second contour line was formed on the bonding surface. Further, the LT substrate portion of the bonded substrate was polished and thinned to 12µm to form a third contour line, thereby a composite substrate was manufactured.

The grinding surface from the first contour line to the fourth contour line of the manufactured composite substrate was formed to have a plane parallel to the bonding surface. The distance between the first contour line and the fourth contour line was 2.5mm.

The grinding surface from the first contour line to the third contour line through the second contour line formed a continuous outer peripheral surface. In the cross section perpendicular to the bonding surface and the tangent line of the second contour line, the angle θ formed by the bonding surface and the outer peripheral surface was formed to be 20 degrees, 25 degrees, 30 degrees, 35 degrees, 40 degrees, 45 degrees, 50 degrees, 55 degrees, 60 degrees, 65 degrees, 70 degrees, 75 degrees, 80 degrees, and 85 degrees, respectively.

The number of chips on the outer periphery of the composite substrate after polishing was examined, and the results shown in Table 1 were obtained. It was confirmed that a particularly good chip suppressing effect was obtained when θ was 30 degrees or more and 75 degrees or less.

**Table 1**

| | Angle *θ* | Number of chips | | Angle *θ* | Number of chips |
|---|---|---|---|---|---|
| Example 2 | 20° | 2 | Example 9 | 55° | 0 |
| Example 3 | 25° | 1 | Example 10 | 60° | 0 |
| Example 4 | 30° | 0 | Example 11 | 65° | 0 |
| Example 5 | 35° | 0 | Example 12 | 70° | 0 |
| Example 6 | 40° | 0 | Example 13 | 75° | 0 |
| Example 7 | 45° | 0 | Example 14 | 80° | 1 |
| Example 8 | 50° | 0 | Example 15 | 85° | 2 |

### <Comparison Example 1>

In the same manner as in Example 1, an intervening layer was provided on a single crystal LT substrate 41 of 6 inch diameter and a single crystal silicon substrate 42. Then, after the surface of each intervening layer was mirror-finished, the plasma activation is performed to the surfaces of the intervening layer 48 and both substrate were bonded to each other on the surface of the intervening layer. In this way, a plurality of bonded substrates were produced.

Next, the outer periphery of the bonded substrate was ground by a chamfering machine, and thereby, a first contour line 44, a fourth contour line 47 were formed on the supporting substrate, and a second contour line 45 was formed on the bonding surface 43. Further, the LT substrate portion of the bonded substrate was polished and thinned to 12µm to form the third contour line 46, thereby a composite substrate 4 was manufactured.

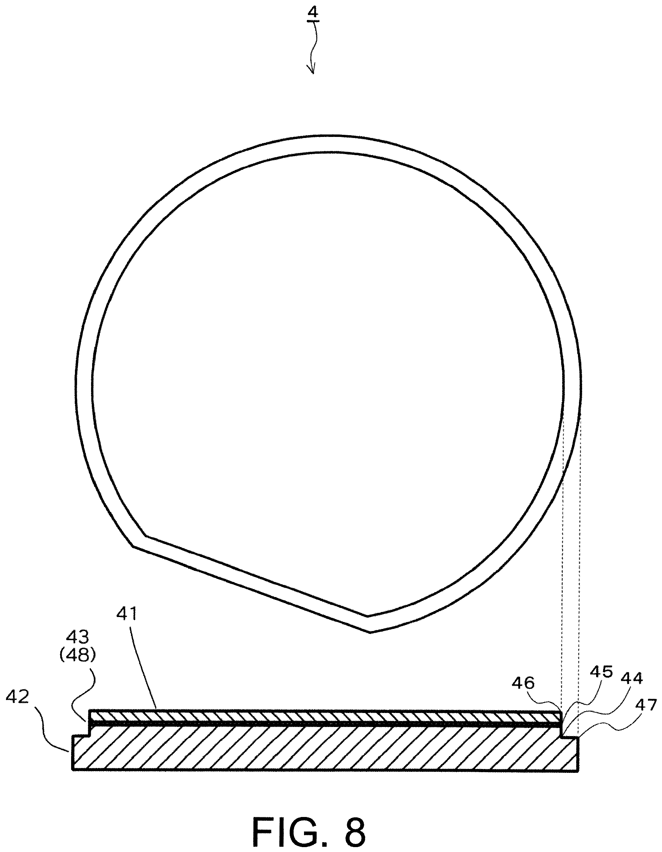

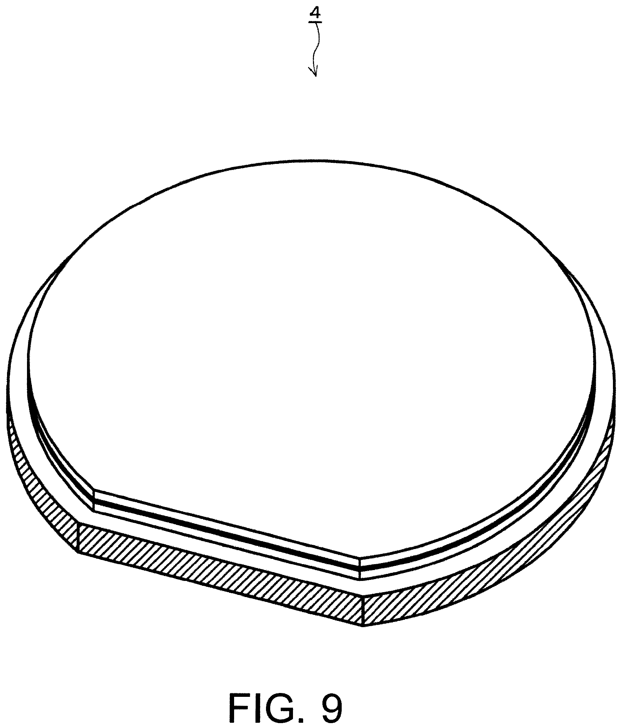

As shown in Figs. 8 and 9, the grinding surface from the first contour line 44 to the fourth contour line 47 of the manufactured composite substrate 4 was formed to have a plane parallel to the bonding surface. The distance between the first contour line and the fourth contour line was 2.5mm.

The grinding surface from the first contour line 44 through the second contour line 45 to the third contour line 46 formed a continuous outer peripheral surface. In the cross section perpendicular to the bonding surface and the tangent line of the second contour line 45, the angle θ formed between the bonding surface 43 and the outer peripheral surface was formed to be 90 degrees.

The number of chips on the outer peripheral portion of the composite substrate 4 after polishing was examined and found to be five.

### <EXAMPLE 16>

An LT substrate of 6 inch diameter and a 46.3°Y-cut was prepared, and the surface to be bonded was mirror-polished. Next, a Si substrate having a thickness of 680µm serving as a supporting substrate was prepared, and a surface to be bonded was mirror-polished. Both the mirror surface of the LT substrate and the mirror surface of the Si substrate were subjected to plasma surface activation, and bond to each other to produce a bonded substrate of 6 inch diameter.

Next, the outer periphery of the bonded substrate of 6 inch diameter was ground by a chamfering machine, and thereby a first contour line and a fourth contour line were formed on the supporting substrate, and a second contour line was formed on the bonding surface.

Further, the LT substrate portion of the bonded substrate was polished and thinned to 12µm to form a third contour line, thereby a composite substrate was manufactured.

The grinding surface from the first contour line to the fourth contour line of the manufactured composite substrate was formed to have a plane parallel to the bonding surface. The distance between the first contour line and the fourth contour line was 2.5mm.

The grinding surface from the first contour line to the third contour line through the second contour line formed a continuous outer peripheral surface. In the cross section perpendicular to the bonding surface and the tangent line of the second contour line, the angle formed between the bonding surface and the outer peripheral surface was 45 degrees.

No chips were formed on the outer periphery of the polished LT substrate portion.

Further, this composite substrate was heated to 300° C with a hot plate, but peeling did not occur at the outer periphery of the bonding surface.

From the above, it was confirmed that the same result as in Example 1 was obtained even in the composite substrate bonded without using the intervening layer.

As described above, by providing each contour line in the order of the third contour line, the second contour line, and the first contour line from the center to the outermost periphery of the composite substrate, it is possible to obtain a composite substrate in which chips are hardly generated at the outer periphery edge of the piezoelectric material layer, and peeling from the outer periphery edge is hardly generated.

The present invention is not limited to the above embodiment. The above-described embodiments are examples, and anything having substantially the same configuration as the technical idea described in the claims of the present invention and having the same operation and effect is included in the technical scope of the present invention.

## Claims

1. A composite substrate for a surface acoustic wave device, in which a piezoelectric material single crystal thin film and a supporting substrate are bonded to each other at a bonding surface, wherein:
the supporting substrate has a closed first contour line;
the bonding surface has a closed second contour line;
the piezoelectric material single crystal thin film has a closed third contour line; and
when the first contour line and the third contour line are projected perpendicularly to a plane including the bonding surface, the projection image of the first contour line is located outside the second contour line, and the projection image of the third contour line is located inside the second contour line.

2. The composite substrate according to claim 1, wherein:
the supporting substrate further comprises a closed fourth contour line; and
when the first contour line and the fourth contour line are projected perpendicularly onto the plane including the bonding surface, the projection image of the fourth contour line is located outside the projection image of the first contour line.

3. The composite substrate according to claim 2, wherein, in a cross section perpendicular to the bonding surface, a distance between the first contour line and an extension line of the bonding surface is not longer than a distance between the fourth contour line and the extension line of the bonding surface.

4. The composite substrate according to any one of claims 1 to 3, wherein the composite substrate has an outer peripheral surface continuous from the first contour line to the third contour line through the second contour line.

5. The composite substrate according to claim 4, wherein an angle formed by the bonding surface and the continuous outer peripheral surface in a cross section in which the second contour line vertically passes is 30 degrees or more and 75 degrees or less.

6. The composite substrate according to any one of claims 1 to 5, wherein an intervening layer is provided between the bonding surface and the piezoelectric material single crystal thin film and/or between the bonding surface and the supporting substrate.

7. The composite substrate according to claim 6, wherein the intervening layer is made of an inorganic material.

8. The composite substrate according to claim 6 or 7, wherein the intervening layer includes any of silicon oxide, silicon oxynitride, amorphous silicon, polycrystalline silicon, amorphous silicon carbide, aluminum oxide, aluminum nitride, tungsten, platinum, platinum rhodium, molybdenum, ruthenium, and titanium.

9. The composite substrate according to any one of claims 1 to 8, wherein the supporting substrate is any one of silicon, sapphire, alumina, glass, silicon carbide, aluminum nitride, and silicon nitride.

10. The composite substrate according to any one of claims 1 to 9, wherein the piezoelectric material single crystal thin film is lithium tantalate or lithium niobate.

11. A method of manufacturing a composite substrate for a surface acoustic wave device comprising:
preparing a piezoelectric material single crystal substrate and a supporting substrate;
bonding the piezoelectric material single crystal substrate and the supporting substrate to form a bonded substrate having a bonding surface;
grinding the outer peripheral surface of the bonded substrate to form a closed first contour line on the supporting substrate and to form a second contour line on the bonding surface, and forming an outer peripheral surface extending from the first contour line across the second contour line to a surface of the piezoelectric material single crystal substrate opposite to the bonding surface; and
polishing and thinning the piezoelectric material single crystal substrate to form a piezoelectric material single crystal thin film having a closed third contour line,
wherein, when the first contour line and the third contour line are projected perpendicularly onto a plane including the bonding surface, the projection image of the first contour line is located outside the second contour line, and the projection image of the third contour line is located inside the second contour line.

12. The method of manufacturing according to claim 11, wherein the outer peripheral surface is continuous from the first contour line to the third contour line through the second contour line.

13. The method of manufacturing according to claim 12, wherein an angle formed by the bonding surface and the continuous outer peripheral surface in a cross section in which the second contour line vertically passes is 30 degrees or more and 75 degrees or less.

14. The method of manufacturing according to any one of claims 11 to 13, wherein in the step of forming the outer peripheral surface of the bonded substrate, a closed fourth outline is further formed on the supporting substrate, and
when the first contour line and the fourth contour line are projected perpendicularly onto a plane including the bonding surface, the projection image of the fourth contour line is outside the projection image of the first contour line.

15. The method of manufacturing according to claim 14, wherein the first contour line and the fourth contour line are formed so that the distance between the first contour line and the extension line of the bonding surface is not longer than the distance between the fourth contour line and the extension line of the bonding surface in a cross section perpendicular to the bonding surface.

16. The method of manufacturing according to any one of claims 11 to 15, further comprises a step of forming an intervening layer on the piezoelectric material single crystal substrate and/or on the supporting substrate prior to the step of forming the bonded substrate,
wherein the intervening layer forms the bonding surface.

17. The method of manufacturing according to claim 16, wherein the intervening layer is made of an inorganic material.

18. The method of manufacturing according to claim 16 or 17, wherein the intervening layer comprises any of silicon oxide, silicon oxynitride, amorphous silicon, polycrystalline silicon, amorphous silicon carbide, and aluminum oxide.

19. The method of manufacturing according to any of claims 11 to 18, wherein the support board is any one of silicon, sapphire, aluminum, glass, silicon carbide, aluminum nitride, and silicon nitride.

20. The method of manufacturing according to any one of claims 11 to 19, wherein the piezoelectric material single crystal substrate is lithium tantalate or lithium niobate.
